Europäisches Patentamt

European Patent Office

Office européen des brevets

(11) Publication number: **0 509 184 A1**

# EUROPEAN PATENT APPLICATION

(21) Application number: 91830154.0

(22) Date of filing: 18.04.91

(51) Int. Cl.⁵: **G11C 16/06**, G11C 8/00

(43) Date of publication of application:
**21.10.92 Bulletin 92/43**

(84) Designated Contracting States:
**DE FR GB IT NL SE**

(71) Applicant: SGS-THOMSON
MICROELECTRONICS s.r.l.
Via C. Olivetti, 2
I-20041 Agrate Brianza Milano(IT)

(72) Inventor: Casagrande, Giulio
Via Strettone, 8
I-20060 Vignate (Milano)(IT)

(74) Representative: Mittler, Enrico et al
c/o Marchi & Mittler s.r.l. Viale Lombardia, 20
I-20131 Milano(IT)

(54) Flash memory erasable by sectors and related writing process.

(57) The memory comprises a matrix of FLASH cells (5) arranged at the intersection of lines (WLi) and columns (BLj) of the same matrix. The cells (5) of each line (WLi) have the respective control gates (9) connected together to allow the line selection and the cells (5) of each column (BLj) have the respective drains (7) connected together to allow the column selection. Several columns (BLj) are arranged in groups (Gl), several groups (Gl) are joined together to form a sector (Sk), several sectors (Sk) are suit- able for forming the matrix. The memory also comprises means of control (19) associated with each sector (Sk) to allow the application of erasing voltages to sectors (Sk) that are distinct and independent of the matrix. The writing operation of the cells of a selected sector of the above matrix involves the application of a source voltage that is lower than the drain voltage across all the cells not contained in the selected sector.

Fig.1

The present invention relates to a FLASH memory erasable by sectors and a process for writing it.

There are currently known, for example from the article by F. Masuoka et al., 1985 IEEE INTERNATIONAL SOLID-STATE CIRCUITS CONFERENCE, Digest of Technical Papers, "A 256K FLASH EEPROM using Triple Polysilicon Technology", FLASH memories which have characteristics intermediate between the more classical EPROM (Electrically Programmable Read Only Memories) and EEPROM memories (Electrically Erasable Programmable Read Only Memories).

In addition to the performance of the EPROM's, the FLASH memory is in fact electrically erasable, but, with respect to the classical EEPROM's, it is erased by blocks (or by sectors) rather than by individual byte and in times of the order of one second rather than of milliseconds as for the EEPROM's.

The FLASH memory has the advantage that it requires an area of silicon per bit near that of the EPROM's and thus an area/bit factor about four times lower than that of the EEPROM's.

Different solutions for FLASH memories with different memory cells and architectures have been proposed, all having as the object that of obtaining the best compromise between cost per byte and performance. Thus, on the one side cells different by area, process, physical features used for writing and erasing operations, circuit architecture, etc.; on the other, as a result, additional performance with respect to the mere block erasing operation, such as, for example, generation of the programming/erasing voltage inside the chip, automatic processing of the erasing algorithm, erasing by sectors.

The most suitable solution and that most commonly used in the state of the art is that proposed in the article by V.N. Kynett et al., 1988 IEEE INTERNATIONAL SOLID-STATE CIRCUITS CONFERENCE, Digest of Technical Papers, "An In-System Reprogrammable 256K CMOS Flash Memory". In this the FLASH cell used, formed by a semiconductor substrate with regions of drain and source suitable for delimiting a channel region, a floating gate superimposed over the channel region with the interposition of gate oxide, a control gate superimposed over the floating gate with the interposition of interpoly oxide and a coating oxide, has a size and structure that are almost the same as that of an EPROM cell obtainable with a similar technology and differs in the production process in a few process steps.

One of these is that related to the formation of the gate oxide of the cell, which is of the order of 100 Ångstrom so as to allow the erasing operation by Fowler-Nordheim tunnelling taking the cell source to about 12 volts, with the control gate and the substrate grounded and the drain floating.

Another fundamental difference with respect to the EPROM consists in a modification of the source junction so that it can reach about 12 volts without there being any appreciable conduction between source and substrate (say, due to band-to-band tunnelling). Such a change can consist in a deeper and gradual junction, say accomplished with the implantation of phosphorus.

The FLASH cells thus obtained can be assenbled in a circuit architecture in the form of a matrix, wherein the matrix itself is erasable integrally in a block.

Such an architecture involves a set of matrix lines or word lines and of matrix columns or bit lines. The matrix columns are organized in groups, the groups in data elements, each of which is destined to memorize a word bit. Each matrix column connects the drains of respective cells arranged along it. Each matrix line connects the control gates of respective cella arranged along it. The sources of all the cells of the matrix are connected together and to a single source line alternatively connectable to ground or to an appropriate source of erasing voltage.

Such an architecture also involves first and second level selection transistors for addressing selected cells of the same matrix cell, which may in turn be selected by addressing the corresponding word line. The first selection level allows the selection of one column only inside each group in the different data elements, the second selection level allows the selection of one group with respect to the other and thus one only among the selected columns of a given data element.

The different data elements are connected to respective switches/voltage regulators for writing word bits in the selected cells of the various data elements and to detection amplifiers for reading the data elements written into the above cells.

It should be noted that both the reading and the writing operations can be accomplished simultaneously for the individual selected cells of the different data elements.

Consider the operation of reading the bits of a word memorized in cells of the matrix in the position i, j in the group k in the different data elements. For this purpose the line i is selected putting the corresponding word line, and thus all the control gates of the cells present on the above line, at 5V. The lines other than line i remain at 0V. A first and a second column selection level is also made by putting the gates of the transistors of the first and second selection level of the column j of the group k of each data element, so as to put the corresponding drains at 1V. The common source line is kept grounded. In this situation the detection amplifiers of the different data elements will read "0" or "1" according to the contents of the addressed cells.

Consider the operation of writing the bits of a word in cells of the matrix in position i, j in the group k in the different data elements. For this purpose the cell selection is made by putting the line of the corresponding cells and thus the control gates to which they belong at 12V, the source line to ground, and sending 6V on the drain of the selected column of each data element or leaving it floating according as to whether a "zero" logic level or a "one" logic level is written.

As far as the erasing operation is concerned, it should be noted that it is not possible to individually erase one cell of the matrix, but only the natrix in its entirety. For this purpose the drains of the cells of all the columns of the matrix are kept floating, while the control gates and the substrates of all the cells are grounded and the common source line is put at 12V.

Of course the need to execute the erasing operation in its entirety represents a disadvantage of this circuit architecture.

A further problem of ths circuit architecture described above is represented by the fact that during the writing step the floating gates of all the virgin cells belonging to the same line are at a voltage equal to about 7.5V, while the sources and drains are grounded. It follows that the gate oxide is subjected to a stress of some 7V for tens of milliseconds. Such a condition is critical and requires an accurate engineering of the parameters of the cell itself.

In an architecture which only allows an erasing operation in its entirety a cell may be subjected to the above stress for a time roughly equal to the writing time of a cell multiplied by the number of columns per data element.

Each writing cycle is preceded by an erasing operation in its entirety, which in turn must be preceded by a writing operation of all the cells: the purpose of this procedure is that of bringing all the cells back to the same level at the end of the erasing operation, and thus any effect of the gate stress suffered earlier is cancelled.

When an erasing operation by sector is introduced this stress condition is greatly heightened. In it a cell belonging to the sector i must suffer the gate stress for the entire time needed to write all the cells of the other sectors by a number of times equal to the number of cycles of writing/erasing allowed by the specification; all this multiplied by two since the writing/erasing cycle involves writing the required pattern and writing all "zeros" before the erasing operation.

In view of this state of the art, a first object of the present invention is that of accomplishing a new FLASH memory architecture erasable by sectors.

A further object is that of accomplishing a process of writing said memory that can limit the intensity of the stress conditions wherein any virgin cells may find themselves during the writing condition.

According to the invention there is thus accomplished a FLASH memory, comprising a matrix of FLASH cells arranged at the intersection of lines and columns of the same matrix, the cells of each line having the respective control gates connected together to allow a line selection, the cells of each column having the respective drains connected together to allow a column selection, several columns being arranged in groups, several groups being joined together to form a sector, several sectors being suitable for forming the matrix, characterized in that it comprises means of control associated with each sector to allow the application of erasing voltages to sectors that are distinct and independent of the matrix.

The use of such circuit architecture allows a rapid erasing operation by sector, which has numerous applicative advantages, such as:

- considering that the content changes to be made often relate to a limited section of the entire memory, an erasing operation by sector allows the execution of such changes in a faster manner and requires a RAM buffer of reduced size;
- the number of changes allowed by the specification can be executed for each sector individually and thus the number of corrections of the content can be much greater than in an erasing operation in its entirety;
- one or more sector can be made non-alterable by the user through the programming of some non-volatile element introduced into the sector's control circuitry.

There is also accomplished according to the invention a writing process of a cell belonging to a line i, column j, group l, sector k, of a matrix of the above type which involves the application of a bias voltage across the control gate of all the cells of line i, the application or otherwise of a first positive voltage across the drain of all the cells of the column j according as to whether a "0" or a "1" is to be written, and the connection to ground of the sources of the cells belonging to the sector k characterized in that it comprises the application of a second positive voltage having a reduced value across the sources of the cells belonging to a sector other than sector k.

As can easily be understood, the voltage applied across the sources of the cells of a sector other than k is transferred through the cells in conduction of line i to the channels and to the drains of the same cells, so that the voltage applied between the floating gate and the channel in the virgin cells arranged on the same line of the matrix which it is required to write, but not belonging to the chosen sector, is substantally reduced. The increase in the stress time to which the virgin cells are subjected is thus compensated.

The features of the present invention shall be made more evident by an embodiment illustrated, as a non-limiting example, in the enclosed drawings, wherein:

Fig. 1 illustrates a circuit diagram of the memory according to the present invention;

Fig. 2 illustrates a vertical cross-sectional view of a FLASH memory cell according to the invention;

Fig. 3 illustrates the situation of cells of different sectors of a FLASH memory according to the invention during a writing process.

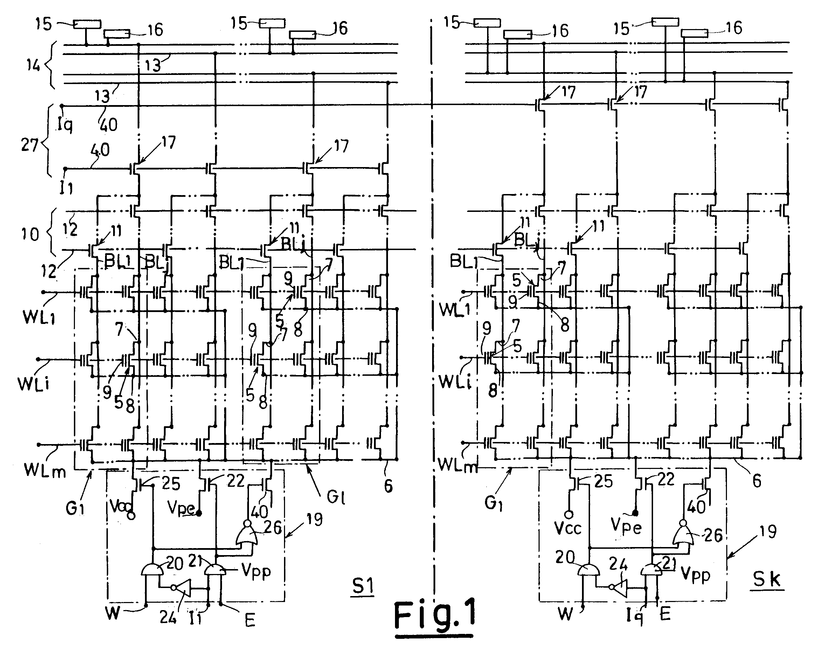

With reference to Fig. 1, the FLASH memory comprises a matrix of FLASH cells 5 arranged at the intersection of lines or word lines WLi, with i = 1..m, and of column or bit lines BLj, with j = 1..n, of the matrix itself. The cells 5 of each line WLi have the control gates 9 connected together through the respective word line WLi. Each BLj column connects together the drains 7 of cells arranged along it. Several BLj columns are grouped into groups Gl, with l = 1..p, several groups are grouped together in sectors Sk, with k = 1..q. The sources of cells belonging to a same sector Sk are connected to a single source line 6.

The memory comprises first means 10 for column selection suitable for selecting columns BLj having the same position in each group Gl of each sector Sk. The first means of selection 10 comprise in particular a set of transistors 11 of the MOS type arranged in a gate connection along a number of selection lines 12 in a number equal to that of the columns BLj of each group Gl. The sources of the transistors 11 of each line 12 are connected to the columns BLj having the same position in the different groups Gl. The gate bias of the transistors 11 of each line 12 thus allows the execution of the above first column selection.

The drains of the transistors 11 corresponding to groups Gl having the same position in the sectors Sk are connected to the same data element line 13 which forms part of a number of data element lines equal to that of the groups Gl of each sector Sk. The lines 13, indicated as a whole with the numerical reference 14, correspond each to a word bit. Each data element line 13 is in turn connected to a respective detection amplifier 15 of the content of the selected cell 5 and to a corresponding switch/voltage regulator 16 for sending one writing bit into the selected cell 5.

Between the first selection means 10 and the set of data element lines 14 there are second selection means 27. The latter are constituted by a set of MOS transistors 17 aligned in succession on a number of sector selection lines 40 equal to the number p of the sectors Sk. The transistors 17 arranged along any one line have the gates connected together, while the source of each of them is connected through the transistors 11 to the columns BLj of a corresponding group Gl and the drain is connected to the detection amplifier 15 and to the switch/voltage regulator 16 corresponding to the above data element. The bias of the gates of the transistors 17 allows the accomplishment of the sector selection.

With each sector Sk there is also associated a control logic 19 suitable for allowing the transmission of signals for the activation of writing operations of the individual cells and for the activation of the erasing operation by sector.

The logic 19 consists in particular of a logic gate AND 20 with inputs connected to a writing signal input W and through an inverter 24 to a signal input Ii, with i = 1..q where q is the number of sectors Sk, identical with that applied at the gates of transistors 17. This latter signal also represents one of the two inputs of a logic gate AND 21, whose other input receives an erasing signal E.

The output of the logic gate 20 controls the gate of an MOS transistor 25. The drain of the MOS transistor 25 is connected to a terminal having a voltage Vcc (substantially equal to 5V), the source is connected to the sources of the cells of sector Sk.

The output of the logic gate 21 controls the gate of an MOS transistor 22. The drain of the transistor 22 is connected to a terminal at a voltage Vpe (substantially equal to 12V), the source is connected to the sources of the cells of sector Sk. The outputs of the logic gates 20, 21 represent the two inputs of a logic gate NOR 26. The output of the logic gate 26 controls the gate of an MOS transistor 40. The source of the transistor 40 is grounded, the drain is connected to the sources of the cells of the sector Sk. It should be noted that the logic gates NOR 26 and AND 21 are supplied at a voltage equal to about 12V, so that, if their output is high, it equals 12V, while the gate AND 20 is supplied at a voltage of about 5V, so that, if its output is high, it equals 5V.

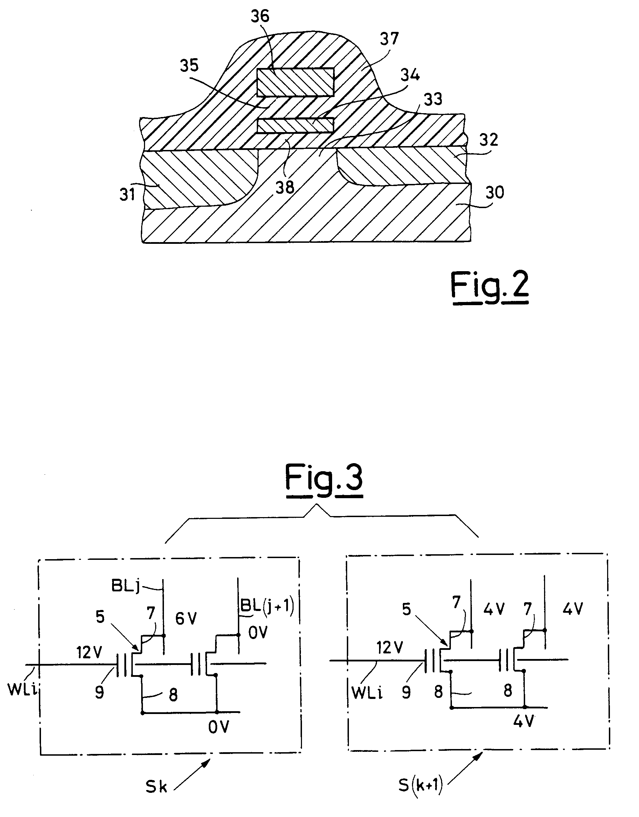

With reference to Fig. 2, eacg FLASH cell 5 is formed by a semiconductor substrate 30 wherein there are obtained a drain region 32 accomplished with the implantation of arsenic and a source region 31 accomplished with the implantation of arsenic and phosphorus and deeper than the drain region 32. Between the drain 31 and source 32 regions there is a channel region 33. At the channel region 33 there is superimposed a gate oxide 38 having a thickness of some 100 Angstrom suitable for separating the channel region 33 from a floating gate 34, over which there is superimposed, with the interposition of interpoly oxide 35, a control gate 36. The cell is then coated entirely with oxide 37. It should be noted that the limited thickness of the gate oxide 38 allows erasing by Fowler-Nordheim tunnelling, taking the source 31 to some 12V, with the control gate and the substrate grounded and the drain floating.

For a matrix of FLASH cells according to Fig.s 1 and 2, the erasing operation can be accomplished by sectors applying the command E to the control logic 19 of the sector it is desired to erase, together with a selection signal of the sector Ii. There is thus started the conduction of transistor 22 on whose drain there is established the voltage Vpe applied across its source, equal to some 12V. All the sources of the cells 5 of the sector are thus at 12V. All the word lines are at 0V; all the selection lines 12 of the selector 10 are similarly grounded so that the bit lines or columns are floating.

The reading or writing operations of data elements, or set of bits, in the matrix is accomplished by means of the use of the detection amplifiers 15 and of the switches/voltage regulators 16, respectively, corresponding to the cells wherein the data element to be read is stored or in which it is required to store the new data element, after selection of the cells themselves.

This involves the selection of the word line WLi and of the bit lines BLj to which the cells belong into which it is required to read or write the data element.

The selection of the word line WLi for reading is made by putting the control gates of the cells 5 belonging to it at 5V.

The selection of the bit lines BLj involves the use of first and second means of selection 10, 27. In particular with the first selection means 10 the column BLj of each group GI in each sector Sk is selected, with the second selection means 27 a sector Sk is selected. In this way as many columns BLj have been selected having the same position in the GI groups of a given sector Sk as there are word bits.

The operation of reading the content of selected cells involves the application, on the part of the corresponding detection amplifiers 15, of a voltage equal to 1V across the drains 17 of the selected cells, as well as the grounding of the respective sources 8. The amplifiers 15 shall at that point detect a "0" or a "1" according to the content of the selected cells. This operation is carried out in parallel on all the bits of the word.

The writing operation involves the application of the writing signal and of the signal Ii across the two inputs of the logic gate 20 of the control logic 19 of the sector Sk to which the cells 5 belong in which the writing operation is to be executed. The bits are then written into selected cells by means of the application of appropriate voltages through the switches/voltage regulators 16.

With reference to the cells belonging to the selected word line, indicated with the reference WLi in Fig. 3, and to the selected sector Sk, the writing operation of a "1" bit or of a "0" bit involves the application of 12V across the selected word line WLi and thus across the control gate 9 of the cells 5 of the above line and the application of 6V, in the case of the writing operation of a "0" bit, across the bit line BLj and thus across the drain of the selected cell; if it is required to write a "1" bit the switch/voltage regulator 16 shall be open, leaving the corresponding bit line floating, forced to ground by a cell in conduction. The bit lines and thus the drains of the cells 5 belonging to the selected sector Sk, but not selected for the writing operation, are, on the other hand, held to ground, that is, at 0V, through a cell in conduction. Moreover, all the sources 8 of the cells of the same sector shall be grounded.

As far as the cells belonging to a sector other than Sk are concerned, for example, the sector S-(k + 1) that has not been selected, the above writing operation involves the application of a voltage equal to about 4V across the sources 8 of the cells and thus, through the cells in conduction, also across the drains.

The application of a positive voltage across the sources 8 of the cells belonging to the selected word line WLi, but not to the selected sector Sk, has the effect of reducing in them the voltage difference between the floating gate 34 and the source-channel-drain set 31, 33, 32, which is thus equal to about 5V. This compensates for the extension of the stress time to which the cells 5 are subjected as a result of the circuit architecture with erasing operations by sector.

**Claims**

1. FLASH memory, comprising a matrix of FLASH cells (5) arranged at the intersection of lines (WLi) and columns (BLj) of the same matrix, the cells (5) of each line (WLi) having the respective control gates (9) connected together to allow a line selection, the cells (5) of each column (BLj) having the respective drains (7) connected together to allow a column selection, several columns (BLj) being arranged in groups (GI), several groups (GI) being joined together to form a sector (Sk), several sectors (Sk) being suitable for forming the matrix, characterized in that it comprises means of control (19) associated with each sector (Sk) to allow the application of erasing voltages to sectors (Sk) that are distinct and independent of the matrix.

2. FLASH memory according to claim 1, characterised in that it comprises first means (10) for column selection suitable for simultaneously selecting a column (BLj) of each group (Gl) in every sector (Sk) and second means (27) for sector selection suitable for selecting the groups (Gl) constituting a sector (Sk).

3. FLASH memory according to claim 2, characterised in that said control means (19) comprise a control logic (19) suitable for allowing the transmission of signals for the activation of writing operations of the individual cells (5) and of signals for the activation of an erasing operation by sector (Sk).

4. Writing process of a cell belonging to a line i (WLi), column j (BLj), group l (Gl), sector k (Sk), of a matrix according to claim 1, comprising the application of a bias voltage across the control gate (9) of all the cells (5) of line i, the application or otherwise of a first positive voltage across the drain (7) of all the cells of the column j according as to whether a "0" or a "1" is to be written, and the connection to ground of the sources (8) of the cells belonging to the sector k, characterized in that it comprises the application of a second positive voltage having a reduced value across the sources (8) of the cells belonging to a sector other than sector k.

**Fig.1**

EP 0 509 184 A1

## Fig.2

## Fig.3

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | GB-A-2 235 999 (INTEL CORPORATION) <br> * the whole document * <br> --- | 1-4 | G11C16/06 <br> G11C8/00 |
| E,X <br> A | GB-A-2 238 637 (SAMSUNG ELECTRONICS CORP.) <br> * page 13, line 22 - page 22, line 31; figures 5-8 * <br> --- | 1 <br> 2,3 | |
| A | EP-A-0 311 137 (NEC CORPORATION) <br> * column 24, line 17 - column 24, line 48; figure 14 * <br> --- | 2 | |
| A | US-A-4 949 309 (CATALYST SEMICONDUCTOR INC.) <br> * column 2, line 15 - column 5, line 39; figure 1; table 1 * <br> ----- | 4 | |
| | | | TECHNICAL FIELDS SEARCHED (Int. Cl.5) <br><br> G11C |

The present search report has been drawn up for all claims

| Place of search | Date of completion of the search | Examiner |
|---|---|---|
| THE HAGUE | 31 JANUARY 1992 | CUMMINGS A. |

EPO FORM 1503 03.82 (P0401)